# EUROPEAN PATENT APPLICATION

(11) **EP 1 626 359 A2**
(43) Date of publication of application: **15.02.2006**
(21) Application number: 05300661.5
(22) Date of filing: 12.08.2005
(51) Int. Cl.: G06F 17/50

(54) **Methods and systems for electronic device modelling**

(30) Priority: 13.08.2004 US 918143
(71) Applicant: ALCATEL, 75008 Paris (FR)
(72) Inventor: GRYBA, John Stephan, K1R 7S7, Ottawa (CA); SHAVER, Steven Carl, K2L 1R8, Ottawa (CA)
(74) Representative: Hervouet, Sylvie

(57) **Abstract**

Electronic device modelling methods and systems are provided. A model of an electronic device is generated by identifying electronic components in the electronic device, searching component models to locate a component model for each electronic component, and recording each component model in a device model for the electronic device. A previously generated device model may subsequently be accessed and updated in a data store. Electronic device structure analysis techniques are also disclosed. Electronic components and any sub-components thereof are identified from a representation of an electronic device, and an indication of any identified components and sub-components is provided. The indication may then be used in generating a model of the electronic device for functional simulation, further structural analysis, or other purposes.

## Description

### Field of the Invention

This invention relates generally to electronic devices and, in particular, to functional simulation of electronic devices.

### Background

During the design of electronic devices, a significant amount of time may be spent in design verification by functional simulation. This effort may include gathering required electronic component models, converting electronic device schematics, often in vendor-specific format, to VHDL (VHSIC (Very High Speed Integrated Circuit) Description Language) code, for example, checking models for validity and/or correct versions, and modifying schematics if required. Thus, the high level process of simulating a design may start with a schematic of an electronic device to be fabricated. The schematic is then exported to a structural VHDL netlist to be simulated with a VHDL simulator.

One problem with conventional simulation techniques is that there is no clear indication of functional, timing, or structural hierarchy information in an exported netlist. It is essentially a text representation, in VHDL format, of components and how they interconnect. Models for the various components in the netlist can come from a large number of sources. Many different third party vendors provide models for standard components; others provide functionality models only for their own components. Functionality can also be provided from a native design source, for a custom FPGA (Field Programmable Gate Array) or ASIC (Application Specific IC), for example. In general, models from a number of different sources are obtained and supported within an organization, and a verification team must gather all of the required models for a particular netlist in order to perform a functional simulation.

Although models provide the functional information for components in a netlist, conventional simulation tools do not provide an indication of component or component model hierarchy. A component or its model may reference, include, call, or otherwise be associated with other components or models. In this case, component models in a simulation model must be compiled in a particular order to avoid errors at compile time. For example, if a model A references a model B, then model B must be compiled before model A. This type of inter-model dependency is often discovered from detailed manual analysis of a netlist or from compile time errors when an associated model required for a currently compiling model has not yet been compiled, such as where model A is compiled before model B in the above example.

Another problem arises with passive and analog components. Currently, VHDL only supports digital simulation. Components such as resistors may be modeled for a particular functionality such as open or short, but other components must be stripped from the netlist. Capacitors and inductors, for example, cannot be simulated and are therefore removed. This requires manipulation of the netlist. Some scripts exist to assist with this process, but they tend not to be intuitive and provide a source of error into the design.

For some electronic devices such as Printed Circuit Boards (PCBs), simulation models are large and complex. They often contain multiple ASICs, FPGAs, and microprocessors. Simulating the entire PCB at once is virtually impossible. As a result, test cases may be created to simulate portions of a board at a time. This also requires modifying and manipulating the netlist. Some components will need to use different functionality models, others will be removed. This process is time consuming and prone to human error.

In addition, a simulation environment may contain a large number of third party tools. For example, there may be a simulator, third party models, memory modelers, hardware modelers, and verification and test bench tools. All of these tools must be configured to reliably interface together into a seamless environment. This may lead to several versions of an environment, created by different designers or testers, which is difficult for future support or when passing a design to a new design team.

There may also be many different preferred design structures for a particular design simulation. This makes it difficult for new team members to become familiar with an entire design. This is primarily due to the complexity and size of the typical overall designs. For example, there may be several types of models, verification sources, and sections (test cases) of a design that must all be placed in a comprehensive manner. However, a structure which is comprehensive for one designer might not be comprehensive to another.

Thus, conventional functional simulation techniques tend to be labor intensive, involving many manual operations which are both time consuming and prone to error, and difficult to support and manage.

### Summary of the Invention

There is a need to reduce the time spent manually preparing and managing an environment in which to perform electronic device functional simulations.

Machine-implemented techniques according to embodiments of the invention simplify functional simulation by automating many of the operations associated with building simulation models, including component model gathering and structural hierarchy identification, for example. Embodiments of the invention also provide for archiving and subsequent updating or completion of simulation models.

One aspect of the present invention provides a machine-implemented method of generating a device model for an electronic device having at least one electronic component. The method includes identifying each of the at least one electronic component, searching component models to locate a component model for each of the at least one electronic component, and recording each component model in a device model for the electronic device.

The operation of identifying, which may be based on a description of the electronic device such as a hardware description language description, may include determining whether each component comprises a sub-component.

In some embodiments, searched component models include component models in different formats. The component models may be stored in multiple directories, including local and remote directories.

Recording of a component model may involve storing in the device model software code for the component model, a pointer to software code for the component model, or possibly both. Component models located during the searching operation may be added to the device model or used to replace previously recorded component models in the device model.

For any electronic components for which a component model is not located, a placeholder component model is preferably recorded in the device model. Placeholder component models may be replaced with a subsequently located component model or deleted from the device model.

A system for generating a device model for an electronic device is also provided. In one embodiment, a system includes an input for receiving a representation of an electronic device and a processor configured to identify electronic components in an electronic device, to search a plurality of component models to locate a component model for each of the electronic components, and to record each component model in a device model for the electronic device.

According to another aspect of the invention, a method of managing a device model for an electronic device having at least one electronic component is provided, and includes accessing the device model in a data store, locating a component model for an electronic component of the electronic device, and recording the component model in the device model.

The data store comprises a local data store or a remote data store.

As described above, recording may include adding a component model to the device model or replacing a component model in the device model with the located component model, for example. A component model in the device model may be replaced with a different version of the component model, a component model of a different format, or a subsequently located component model in the case of a placeholder component model, for instance.

In some embodiments, a determination as to whether to record a component model in the device model or to discard the component model is made based on user input.

An electronic device model management system is also provided, and in one embodiment includes an interface and a processor which is configured to access the device model in a data store, to locate a component model for an electronic component of the electronic device, and to record the component model in the device model.

A further aspect of the invention provides a machine-implemented method of electronic device structure analysis. The method includes operations of identifying an electronic component of the electronic device from a representation of the electronic device, determining whether the component comprises a sub-component, repeating the operations of identifying and determining, for the sub-component, where the electronic component comprises a sub-component, or for another electronic component of the electronic device, where the electronic component does not comprise a sub-component, and providing an indication of any identified components and sub-components of the electronic device.

The operations of identifying and determining may be repeated for each electronic component of the electronic device or a subset thereof. The subset may, for example, include electronic components which are lower than a user-specified electronic component in a hierarchical structure of the electronic device.

An electronic device structure analysis system according to another aspect of the invention includes an input for receiving a representation of the electronic device and a processor, the processor being configured to identify an electronic component of the electronic device from a representation of the electronic device, to determine whether the component comprises a sub-component, and to provide an indication of any identified components and sub-components of the electronic device. The processor preferably repeats the operations of identifying and determining, for the sub-component, where the electronic component comprises a sub-component, or for another electronic component of the electronic device, where the electronic component does not comprise a sub-component.

Other aspects and features of embodiments of the present invention will become apparent to those ordinarily skilled in the art upon review of the following description of specific illustrative embodiments of the invention.

### Brief Description of the Drawings

Examples of embodiments of the invention will now be described in greater detail with reference to the accompanying drawings, in which:
Fig. 1 is a flow diagram of a method according to an embodiment of the invention;
Fig. 2 is a block diagram of a system in accordance with an embodiment of the invention;
Fig. 3 is a flow diagram of a method according to another embodiment of the invention;
Fig. 4 is a flow diagram illustrating a method of yet another embodiment of the invention;
Fig. 5 is a flow diagram of a more detailed example of the method shown in Fig. 4; and
Fig. 6 is a block diagram illustrating a simulation system facilitated by embodiments of the invention.

### Detailed Description of Preferred Embodiments

Embodiments of the invention provide a tool for preparing a common simulation infrastructure for electronic devices. The tool may provide any or all the following functions: locating and retrieving required component models, verifying the validity/versioning of the models, automatically converting schematics in vendor-specific format to VHDL or some other representation, removing components unnecessary for a simulation to speed up the simulation (e.g. terminations and de-coupling capacitors), and creating a list of compile-time dependencies to ensure that updated files are properly compiled. The tool thereby allows designers to focus on verifying designs instead of creating and maintaining a simulation infrastructure, which may help shorten the design cycle.

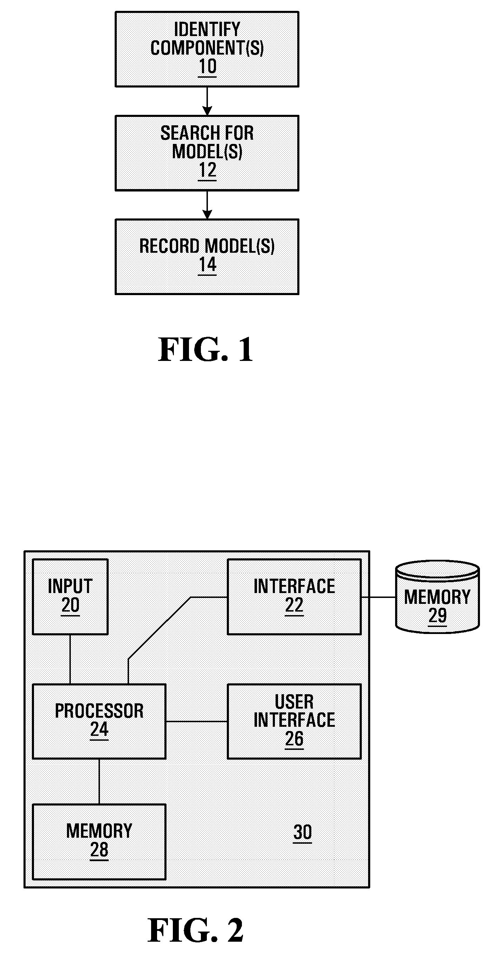

Fig. 1 is a flow diagram of a method according to an embodiment of the invention. It should be appreciated that the method of Fig. 1, as well as the contents of the other drawings, are intended solely for illustrative purposes, and that the present invention is in no way limited to the particular example embodiments explicitly shown in the drawings and described herein.

The method of Fig. 1 relates to generating a simulation model for an electronic device having at least one electronic component, and is preferably machine-implemented, using a processor as described in further detail below with reference to Fig. 2. An electronic device may be a PCB, for example. However, the invention is in no way limited to any particular type of electronic device or components.

The method begins at 10 with identifying each electronic component of the electronic device. At 12, component models are searched to locate a component model for each of the electronic components. Each located component model is then recorded in a simulation model for the electronic device at 14.

The operation of identifying at 10 may include, for example, identifying each electronic component from a description of the electronic device, illustratively a VHDL description. In one embodiment, an electronic device description is generated by converting a schematic diagram of the electronic device to VHDL code. However, it should be appreciated that embodiments of the invention may be implemented in conjunction with other types of diagram, other hardware description languages (HDLs), such as Verilog and Abel for instance, and other types of electronic device representation. In addition, embodiments of the invention may support multiple types of HDL models or components.

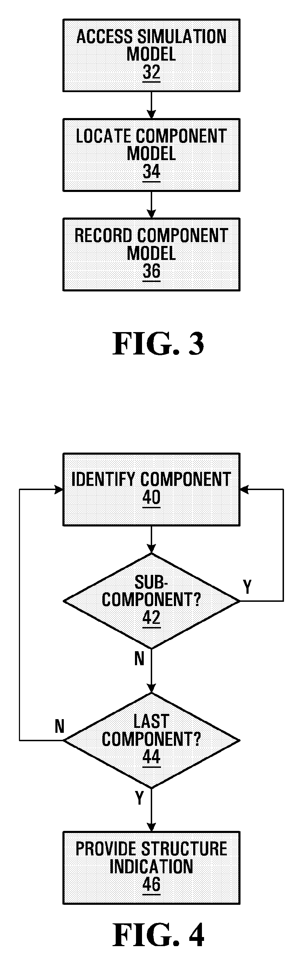

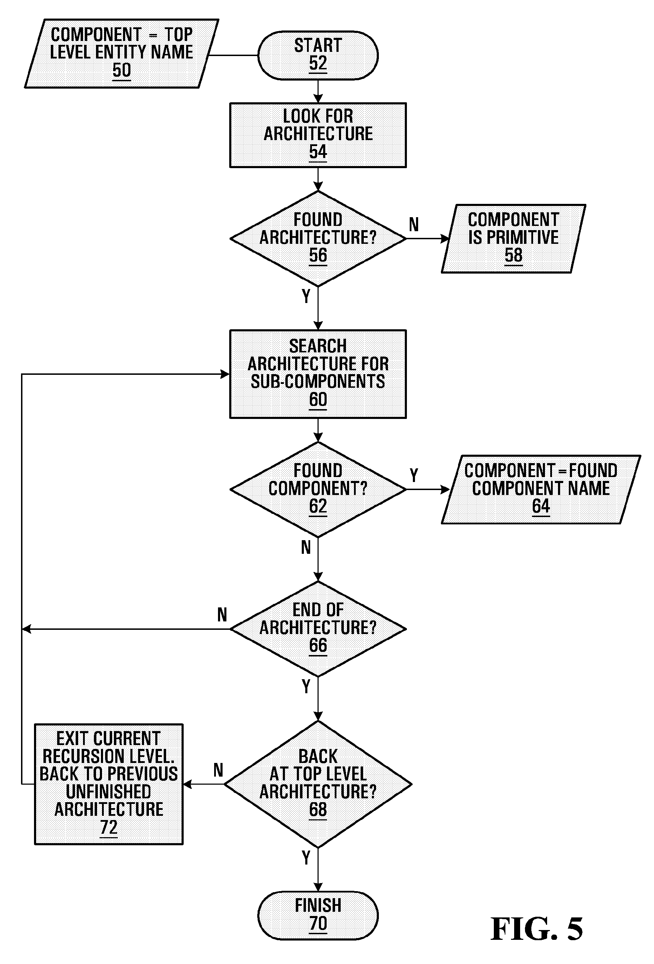

Identifying may also include determining whether each component comprises a sub-component. A hierarchical structure of an electronic device may thereby be identified without detailed manual analysis of a netlist, as described in further detail below with reference to Figs. 4 and 5.

The component models searched at 12 may include component models in different formats or different versions of component models for the same component, for example. Where more than one component model is located for a component, a user may be prompted to select one of the component models.

Although known simulation tools are restricted to accessing predetermined storage locations, often a single directory, for component models, multiple locations or directories are preferably searched at 12. In some embodiments, searching begins within a local data store, and a remote data store is then searched for component models for any components for which component models were not located in the local store. The remote data store may include a central repository of component models which is made available to all verification systems within a company through a corporate network, for example. It is also contemplated that a remote store may include a public repository which is accessible through a public network such as the Internet for instance.

The recording operation at 14 may involve storing software code for each component model, a pointer to software code for each component model, or possibly both, in the simulation model. In accordance with an embodiment of the invention, a common directory structure is used for all simulation models to thereby standardize simulation model format. Component model software code and/or pointers are then stored at predetermined locations within the simulation model structure.

For a new simulation model, component models are recorded at 14 by adding information to the simulation model, by storing new software code and/or a pointer in the simulation model, for example. In some embodiments, however, recording at 14 involves replacing a previously recorded component model in the simulation model. The previously recorded component model may be a "dummy" or placeholder component model recorded in the simulation model for any electronic component for which a component model is not located. In this case, the placeholder component model is preferably replaced with a subsequently located component model. A recorded component model may also be replaced with a different version or format of the component model, for example. Other situations in which replacement of a component model may be desired or required will also be apparent to those skilled in the art.

A placeholder component model may also be used when components such as termination resistors, de-coupling capacitors, or other components which cannot be simulated or can be removed from a simulation model to reduce simulation time, for example, have been identified. Placeholder component models for such components may be either configured to model certain functions or entirely removed from a simulation model.

Although model generation has been described above primarily in the context of modelling for functional simulation of an electronic device, it should be appreciated that embodiments of the invention may also be applied more generally to modelling of electronic devices for purposes other than functional simulation, at virtually any stage in the design process. This may include synthesis, post place and route simulation, for instance. References herein to simulation models should thus be interpreted accordingly as not being restricted to electronic device models for use in functional simulation.

Fig. 2 is a block diagram of a system in accordance with an embodiment of the invention. The system 30 includes a processor 24 connected to an input 20, an interface 22 to a memory 29, a user interface 26, and a memory 28. In one embodiment, the system 30 is implemented in a computer system or other processing device which may include further components which have not been explicitly shown in Fig. 2 to avoid congestion. It will also become apparent from the following description that embodiments of the invention need not necessarily include all of the elements shown in Fig. 2. Thus, embodiments of the invention may be implemented in systems which include fewer or further elements than those shown in Fig. 2.

The input 20 is an element for receiving a representation of an electronic device, and may include, for example, a data bus or connection for receiving the representation from a local source or an interface for receiving the representation from a remote source. Although shown as a single block, the input 20 may include multiple types of input device for receiving electronic device representations from multiple sources.

The interface 22 provides access to component models stored in the remote memory 29, and may include, for example, a network interface device where the memory 29 is provided at a server in a corporate network. As described above, the memory 29 may be a publicly accessible repository, in which case the interface 22 may include an interface to the Internet or some other public network. Many different types of interface will be apparent to those skilled in the art. The particular type of the interface 22 will be dependent upon the access mechanism supported for the memory 29. Like the input 20, the interface 22 may include multiple interface devices for accessing multiple remote memories. It is also contemplated that a single element may act as both an input for receiving a representation of an electronic device and an interface for accessing a remote data store.

The user interface 26 represents one or more elements for receiving inputs from a user, providing outputs to a user, or both. A keyboard and a mouse are examples of elements for receiving user inputs, and a display and a printer are illustrative example output devices. A touchscreen display provides both input and output functionality. Other types of input and output devices will be apparent to those of skill in the art to which the present invention pertains. Although shown in Fig. 2 as an element within the system 30, it should be appreciated that the user interface 26 may include such elements as a receiver, a transmitter, or both, for receiving user inputs from and/or providing outputs to external or remote systems or locations.

The memory 28 represents a local memory device, and may include, for example, any of solid state memory devices, disk drives, and other memory devices adapted to operate with fixed or removable memory media.

In one embodiment, the processor 24 is a microprocessor which executes software stored in the memory 28. The processor 24 may instead be implemented as a microcontroller, an ASIC, or other processing element. Embodiments of the invention may be implemented using a dedicated processor or a processor which also performs other functions. For example, the processor 24 may execute operating system software and software applications to support functions other than those disclosed herein.

For generating a simulation model for an electronic device as described above, the processor 24 is configured to identify each electronic component of the electronic device based on a representation of the electronic device received by the input 20, to search component models to locate a component model for each identified electronic component, and to record each component model in a simulation model. As will be apparent, the processor 24 may be configured to perform these and other functions by executing software.

The representation of the electronic device may be a schematic diagram of the electronic device. In this case, the processor is preferably further configured to convert the schematic diagram into a description of the electronic device and to identify electronic components based on the description of the electronic device. Alternatively, the representation received by the input 20 may be a description of the electronic device instead of a schematic diagram. Thus, conversion of a schematic diagram into an electronic device description may be performed by the system 30 or by an external system or device. As described above, the description of the electronic device may be a VHDL description, for example.

The processor 24 may be further configured to determine whether each electronic component includes an associated sub-component.

Searching for component models, as described above, may include searching multiple directories of component models. The directories may include directories of a local data store in the memory 28, directories of a remote data store in the memory 29, or directories of both the local data store and the remote data store. In one embodiment, the processor is configured to first search the component models stored in the local data store, and then search component models stored in the remote data store to locate a component model for any electronic components for which a component model is not located in the local data store.

Embodiments of the invention relating to generating simulation models have been described above. Fig. 3 is a flow diagram of a method according to another embodiment of the invention, relating to archiving and subsequently managing a simulation model for an electronic device.

The method of Fig. 3 includes operation of accessing a simulation model in a data store at 32, locating a component model for an electronic component of the electronic device at 34, and recording the component model in the simulation model at 36. The data store in which the simulation model is stored may be a local data store or a remote data store.

Recording of the component model at 36 may involve adding the component model to the simulation model, where a component model was not located before the simulation model was stored, for example. The recording operation at 36 may also or instead involve replacing a component model in the simulation model with the located component model. For instance, the located component model may be a different version of the component model in the simulation model or a component model of a different format than the component model in the simulation model. In some embodiments, the simulation model includes a placeholder component model for any electronic component for which a component model was not previously located. A placeholder component model may then be replaced in the simulation model with the located component model.

The recording operation at 36 may also be dependent upon a user input. Based on an input received from a user, in response to a prompt to confirm that the located component model should be stored in the simulation model or used to replace a component model in the simulation model, for example, the component model located at 34 may be recorded or discarded. Prompting a user in this manner allows the user to control which version or format of a component model is to be included in the simulation model.

In most embodiments, the simulation model would be updated by the recording operation at 36 in the same data store from which it was accessed. However, it should be appreciated that other update mechanisms may also be supported, with the simulation model being accessed in one data store and then stored and updated in a different data store. The updated simulation model may thereafter be maintained in the different data store or propagated back to the original data store, after it has been compiled properly or otherwise verified, for instance.

A simulation model management system providing for the above operations may have a structure substantially similar to the system 30 of Fig. 2. For simulation model management, the simulation model may be stored in a data store of the memory 28 and accessed through an internal interface of the system 30, a data store of the memory 29 and accessed through the interface 22, or a data store of some other memory device and received through another interface, such as the input 20. The processor 24 would also be configured somewhat differently, to access the simulation model through the appropriate interface, to locate the component model, and to record the component model in the simulation model. Component models used by the processor 24 may be stored in the same data store or memory device as the simulation model or in one or more different data stores.

Where user control of component model recording is supported, user inputs are received through the user interface 26. In one embodiment, user control is supported through command line inputs entered using a keyboard. However, other types of user interface may also or instead be used, such as a graphical user interface in which control inputs are effected by selecting icons or other graphical elements using a mouse, pointing device, or touchscreen, for example.

Fig. 4 is a flow diagram illustrating a method of yet another embodiment of the invention. The method of electronic device structure analysis of Fig. 4 is preferably machine-implemented, and includes, at 40, identifying an electronic component of an electronic device from a representation of the electronic device, determining at 42 whether the electronic component includes a sub-component, and repeating the operations of identifying at 40 and determining at 42, for the sub-component, where the electronic component includes a sub-component. The operations at 40 and 42 are repeated for other electronic components of the electronic device, if any, as determined at 44, where the electronic component does not include a sub-component. At 46, an indication of any identified components and sub-components of the electronic device is provided.

The operations of identifying at 40 and determining at 42 may be repeated for each electronic component of the electronic device or only a subset of the electronic components of the electronic device. The determination as to a last component at 44 may thus be made by determining whether all components of the electronic device or the subset have been identified. In one embodiment described in further detail below with reference to Fig. 5, the subset of electronic components includes electronic components which are lower than a user-specified electronic component in the hierarchical structure of the electronic device.

The indication provided at 46 may be a visual indication or a printed indication, for example. The method of Fig. 4 thus provides an indication of electronic device structure without requiring detailed manual analysis of a netlist or other representation of the electronic device. In one embodiment, the indication is in the form of a sorted netlist, from which structural hierarchy and primitive components would be apparent. Such a sorted netlist also effectively creates compile-time dependencies to ensure that component models are compiled in a proper order during a subsequent simulation operation, for example.

Thus, it will be apparent from the foregoing that the method of Fig. 4 may be used to determine a hierarchical structure of an electronic device. An indication of the structure may also or instead be used for other purposes, such as functional simulation of an electronic device. In the context of the method of Fig. 1, for example, a sorted netlist generated at 46 might be used as a representation from which electronic components of an electronic device are identified.

A system substantially similar in structure to the system 30 of Fig. 2 may also be used to provide for electronic device structural analysis. For example, a representation of the electronic device may be received through the input 20, the interface 22, or from the memory 28 through an internal interface. In order to enable structural analysis as described above, the processor 24 is configured to identify electronic components of the electronic device from the representation of the electronic device, to determine whether the component includes a sub-component, to repeat the operations of identifying and determining, for the sub-component, where the electronic component includes a sub-component, or for another electronic component of the electronic device, where the electronic component does not include a sub-component, and to provide an indication of any identified components and sub-components of the electronic device, such as through the user interface 26. User inputs received through the user interface 26 preferably control the components for which the identifying and determining operations are repeated.

The processor 24 may be configured to perform the operations of identifying and determining by executing a parser engine or other software application, utility, or module, and to repeat the operations of identifying and determining by calling the parser engine for the sub-component or the other component.

Fig. 5 is a flow diagram of a more detailed example of the method shown in Fig. 4. The flow diagram in Fig. 5 shows parsing of a VHDL netlist as an illustrative example of an electronic device representation. As will be apparent from the foregoing description of an electronic device analysis system, the operations of Fig. 5 may be implemented using a VHDL parser engine.

In accordance with an embodiment of the invention, a parser engine determines the structural hierarchy of an electronic device or design, the names of electronic components in the design, and available functional component models for the electronic components. Placeholder component models for any electronic components with no available models are also preferably created. Information for all identified electronic components and component models are preferably stored for later analysis, test case manipulation, or other processing.

As those skilled in the art will appreciate, VHDL consists of entities and architectures for each component in a netlist. The entity is comparable to a "black box" that defines the interface to the component and the architecture provides the functionality. Hierarchy is formed by instantiating the entities as components. These components can also contain sub-components. In a netlist, there are often many levels of hierarchy. Any level of hierarchy that contains components is not strictly an actual component itself.

Referring now to Fig. 5, at 50, a top level entity name is entered by a user or inferred from a location in a directory structure for a simulation model from which the parser was launched. The parsing method begins at 52, and proceeds to search for an architecture for the top level entity at 54. If an architecture is not found, as determined at 56, then the component is primitive, as indicated at 58, and the electronic device does not include any hierarchical levels below the top level entity.

If the parser finds an architecture for a component at a current level of the hierarchy, as determined at 56, it calls itself (the parser) again at 60 with the new component name. It then searches the found architecture for more components at 62. This process repeats until no more components are found for a particular architecture, as determined at 66. Components found at 62 are flagged as primitive at 64, for a subsequent model gathering phase, for example. The parser then determines at 68 whether the completed architecture is a top level architecture associated with the top level entity and if not, backs up to a previously called architecture at 72 and continues looking for components. The method ends at 70 when the parser has completed or backed up to the top level architecture.

Design parsing will be further illustrated with reference to a simple example design with the following hierarchy:
Top_Entity_Architecture
   Component1
      Sub_comp1A
      Sub_comp1B
   Component2
      Sub_comp2A
   Component3
      Sub_comp3A
      Sub_comp3B
      Sub_comp3C
   Component4
   Component5
End

The parser starts looking for components with the Top_Entity_Architecture. First it finds Component1. The parser is then called again recursively to look for the Component1 architecture and searches for components. It finds Sub_comp1A. It then calls itself recursively, again looking for components. This time it does not find any components and marks Sub_comp1A as primitive, and exits. Since the previous Component1 architecture had not been completed before the parser recursed to Sub-compt1A, it keeps searching and finds Sub_comp1B. This process repeats until the end of the Top_Entity_Architecture has been reached at Component5.

Once all of the primitive components have been identified, functional component models may be located, substantially as described above. If a component model is found for a component, then it is preferably recorded in a simulation model. If a functional model cannot be found, a placeholder entity and possibly an architecture may be created, so as to avoid errors during component model gathering, for example.

In one embodiment, a database which reflects the entire board design is built by the parser. The database maintains information for each component in the design for rebuilding the VHDL netlist, if necessary. This enables, for instance, relatively easy and efficient test case generation.

As described above, test cases may be generated when designs are too large and complex to handle in their entirety. In the above example, a test case might be generated where only Component3 is to be simulated. A designer then provides appropriate control inputs to create a test case scenario for just Component3 in the hierarchy, which would automatically encompass all of the Component3 sub-components. Since embodiments of the invention automatically identify electronic device structures, the designer need not even be aware of the sub-components. Top level VHDL entity and architecture files would be written for just Component3 and the associated configuration file for the test case. This will be compiled by a configured simulator and is then ready for simulation. In order to preserve the integrity of a master netlist, the netlist for the entire design is preferably not overwritten during test case generation even though all tests are preferably generated from the master netlist. For example, support may be provided for different schematic versions of a design, with each test case being tagged against a corresponding schematic version.

The above feature of replacement of component models in a simulation model may also be clearly illustrated in the context of the above example test case. For example, if Sub_comp3B were to be "black boxed" to verify the correlation between Sub_comp3A and Sub_comp3C, the designer may specify a new architecture or component type for Sub_comp3B. If that new type exists for that component, it is mapped into a database or files for the test case to thereby replace Sub_comp3B in the simulation model. Otherwise, blank files may be created for Sub_compt3B. This type of functionality is not available in currently known electronic device modelling systems.

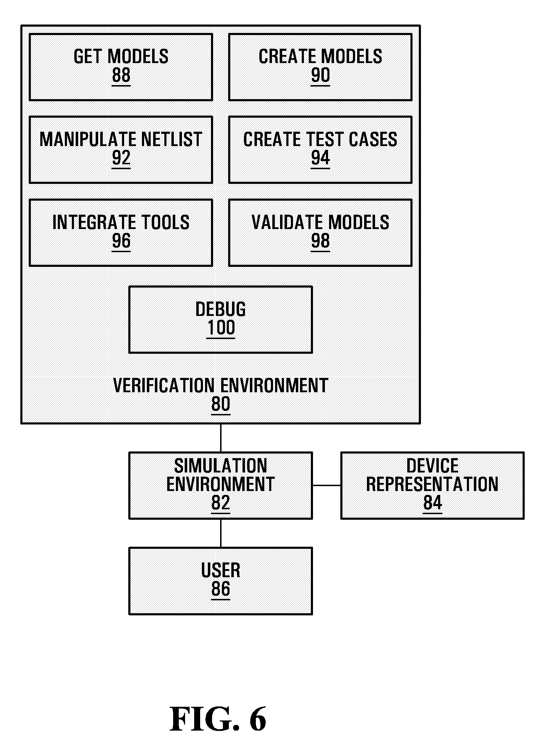

Fig. 6 is a block diagram illustrating a simulation system facilitated by embodiments of the invention. In Fig. 6, a verification environment 80 in which simulation models are generated and manipulated is shown as encompassing various functions, including getting component models at 88, creating component models at 90, manipulating a netlist at 92, creating test cases at 94, integrating various simulation tools at 96, validating component models and/or simulation models at 98, and debugging component models and/or simulation models at 100. From a high level, the simulation environment 82, which may support any of the methods and operations described above or any combinations thereof, provides a single point of entry into an entire electronic device simulation process for a user 86. A common simulation environment enables commands for building, managing, and manipulating a netlist and the verification environment 80 based on a representation 84 of an electronic device, for example, to be made intuitive and constant for any user and any design. In addition, when new models are available or third party tools change, the simulation environment 82 can be reconfigured to incorporate the changes.

Thus, a user need only be familiar with the simulation environment 82, and not each element of the verification environment 80. In currently used design verification techniques, a designer often spends more time in the verification environment 80 than with actual simulation. Embodiments of the invention effectively remove the user 86 from the verification environment 80, enabling more simulation in less time, with one centrally managed interface to models, tools and processes.

What has been described is merely illustrative of the application of the principles of the invention. Other arrangements and methods can be implemented by those skilled in the art without departing from the scope of the present invention.

For example, although described primarily in the context of methods and systems, other implementations of the invention are also contemplated, as instructions stored on a computer-readable medium, for example.

## Claims

1. A machine-implemented method of generating a device model for an electronic device having at least one electronic component, comprising:
identifying each of the at least one electronic component;
searching a plurality of component models to locate a component model for each of the at least one electronic component; and
recording each component model in a device model for the electronic device.

2. The method of claim 1, wherein identifying comprises identifying each electronic component from a description of the electronic device.

3. The method of claim 2, wherein the description comprises an HDL (Hardware Description Language) description.

4. The method of any one of claims 1 to 3,
wherein identifying comprises, for each electronic component, determining whether the component comprises at least one sub-component.

5. The method of any one of claims 1 to 4, wherein the plurality of component models comprises component models in different formats.

6. The method of any one of claims 1 to 5, wherein searching comprises searching a plurality of directories.

7. The method of any one of claims 1 to 6, wherein recording comprises storing in the device model at least one of software code for each component model and a pointer to software code for each component model.

8. The method of any one of claims 1 to 7, wherein recording comprises replacing a previously recorded component model in the device model.

9. The method of claim 8, wherein recording further comprises recording a placeholder component model in the device model for any of the at least one electronic component for which a component model is not located, and wherein replacing comprises replacing a placeholder component model in the device model with a subsequently located component model.

10. The method of any one of claims 1 to 9, further comprising:
simulating operation of the electronic device using the device model.

11. A machine-readable medium storing instructions which when executed perform the method of any one of claims 1 to 10.

12. A system for generating a device model for an electronic device having at least one electronic component, the system comprising:
means for identifying each of the at least one electronic component;
means for searching a plurality of component models to locate a component model for each of the at least one electronic component; and
means for recording each component model in a device model for the electronic device.

13. The system of claim 12, further comprising:
an input for receiving a representation of the electronic device,
wherein at least one of the means for identifying, the means for searching, and the means for recording are implemented by a processor.

14. The system of claim 13, wherein the representation of the electronic device comprises a diagram of the electronic device, and wherein the processor is further configured to convert the diagram into a description of the electronic device, and to identify each of the at least one electronic component based on the description of the electronic device.

15. The system of claim 13 or claim 14, wherein the representation of the electronic device comprises an HDL (Hardware Description Language) description of the electronic device.

16. The system of any one of claims 13 to 15, wherein the processor is further configured to determine whether each electronic component comprises at least one associated sub-component.

17. The system of any one of claims 12 to 16,
wherein the plurality of component models comprises component models in different formats.

18. The system of any one of claims 12 to 17, wherein searching comprises searching a plurality of directories.

19. The system of claim 18, further comprising:
a local data store,
wherein the plurality of directories comprises directories of the local data store, directories of a remote data store, or directories of both the local data store and the remote data store.

20. The system of any one of claims 13 to 16, further comprising:
a local data store storing component models,
wherein the processor is configured to search the component models stored in the local data store to locate a component model for each of the at least one electronic component, and to search component models stored in a remote data store to locate a component model for any electronic components for which a component model is not located in the local data store.

21. The system of any one of claims 13 to 16, wherein the processor is configured to record each component model in the device model by storing in the device model at least one of software code for each electronic component model and a pointer to software code for each electronic component model.

22. The system of any one of claims 12 to 21, further comprising:
means for simulating operation of the electronic device using the device model.

23. A method of managing a device model for an electronic device having at least one electronic component, the method comprising:
accessing the device model in a data store;
locating a component model for an electronic component of the electronic device; and
recording the component model in the device model.

24. The method of claim 23, wherein the data store comprises a local data store or a remote data store.

25. The method of claim 23 or claim 24, wherein recording comprises adding the component model to the device model.

26. The method of claim 23 or claim 24, wherein recording comprises replacing a component model in the device model with the located component model.

27. The method of claim 26, wherein the located component model comprises a different version of the component model in the device model or a component model of a different format than the component model in the device model.

28. The method of claim 26, wherein the simulation model comprises a placeholder component model for any of the at least one electronic component for which a component model was not previously located, and wherein replacing comprises replacing a placeholder component model in the simulation model with the located component model.

29. The method of claim 23 or claim 24, wherein recording comprises storing in the device model at least one of software code for each component model and a pointer to software code for each component model.

30. The method of claim 23 or claim 24, further comprising:
receiving a user input; and
determining whether to record the located component model in the device model or to discard the located component model based on the user input.

31. The method of any one of claims 23 to 30, further comprising:
simulating operation of the electronic device using the device model.

32. A machine-readable medium storing instructions which when executed perform the method of any one of claims 23 to 31.

33. An electronic device model management system comprising:
means for accessing the device model in a data store;
means for locating a component model for an electronic component of the electronic device; and
means for recording the component model in the device model.

34. The system of claim 33, further comprising:
an interface,
wherein at least one of the means for accessing, the means for locating, and the means for recording are implemented by a processor.

35. The system of claim 33 or claim 34, wherein the data store comprises a local data store or a remote data store.

36. The system of claim 34, wherein the processor is configured to locate the component model in the data store.

37. The system of claim 34, wherein the processor is configured to record the component model in the device model by adding the component model to the device model.

38. The system of claim 34, wherein the processor is configured to record the component model in the device model by replacing a component model in the device model with the located component model.

39. The system of claim 38, wherein the located component model comprises a different version of the component model in the device model or a component model of a different format than the component model in the device model.

40. The system of claim 38, wherein the simulation model comprises a placeholder component model for any of the at least one electronic component for which a component model was not previously located, and wherein replacing comprises replacing a placeholder component model in the simulation model with the located component model.

41. The system of claim 34 or claim 36, further comprising:
a user interface configured to at least receive inputs from a user,
wherein the processor is further configured to determine whether to record the located component model in the device model or to discard the located component model based on a received user input.

42. The system of claim 34 or claim 36, wherein the processor is configured to record each component model in the device model by storing in the device model at least one of software code for each component model and a pointer to software code for each component model.

43. The system of any one of claims 33 to 42, further comprising:
means for simulating operation of the electronic device using the device model.

44. A machine-implemented method of electronic device structure analysis, comprising:
identifying an electronic component of the electronic device from a representation of the electronic device;
determining whether the component comprises a sub-component;
repeating the operations of identifying and determining, for the sub-component, where the electronic component comprises a sub-component, or for another electronic component of the electronic device, where the electronic component does not comprise a sub-component; and
providing an indication of any identified components and sub-components of the electronic device.

45. The method of claim 44, wherein the operations of identifying and determining are repeated for each electronic component of the electronic device.

46. The method of claim 44, wherein the operations of identifying and determining are repeated for a subset of a plurality of electronic components of the electronic device.

47. The method of claim 46, wherein the subset of the plurality of electronic components comprises electronic components which are lower than a user-specified electronic component in a hierarchical structure of the electronic device.

48. The method of any one of claims 44 to 47, wherein the representation of the electronic device comprises an HDL (Hardware Description Language) description of the electronic device.

49. The method of any one of claims 44 to 48, wherein providing comprises providing at least one of a visual indication and a printed indication.

50. The method of any one of claims 44 to 49, further comprising:
generating a simulation model of the electronic device based on the indication.

51. A machine-readable medium storing instructions which when executed perform the method of any one of claims 44 to 50.

52. An electronic device structure analysis system, comprising:
means for identifying an electronic component of the electronic device from a representation of the electronic device;
means for determining whether the component comprises a sub-component,
wherein the means for identifying and the means for determining repeat the operations of identifying and determining, for the sub-component, where the electronic component comprises a sub-component, or for another electronic component of the electronic device, where the electronic component does not comprise a sub-component; and
means for providing an indication of any identified components and sub-components of the electronic device.

53. The system of claim 52, further comprising:
an input for receiving the representation of the electronic device,
wherein at least one of the means for identifying, the means for determining, and the means for providing are implemented in a processor.

54. The system of claim 53, wherein the processor is configured to identify and determine by executing a parser engine, and to repeat the operations of identifying and determining by calling the parser engine for the sub-component or the other component.

55. The system of claim 53 or claim 54, wherein the processor is configured to repeat the operations of identifying and determining for each electronic component of the electronic device.

56. The system of claim 53 or claim 54, wherein the processor is configured to repeat the operations of identifying and determining for a subset of a plurality of electronic components of the electronic device.

57. The system of claim 56, further comprising:
a user interface for at least receiving inputs from a user,
wherein the subset of the plurality of electronic components comprises electronic components which are lower in a hierarchical structure of the electronic device than an electronic component specified in a user input.

58. The system of any one of claims 52 to 57, further comprising:
means for generating a simulation model of the electronic device based on the indication.
